# EUROPÄISCHE PATENTSCHRIFT

(11) **EP 1 277 241 B1**
(45) Veröffentlichungstag und Bekanntmachung des Hinweises auf die Patenterteilung: **13.12.2017**
(21) Anmeldenummer: 01931364.2
(22) Anmeldetag: 16.03.2001
(51) Int. Cl.: H01L 33/40, H01L 33/42

(54) **LUMINESZENZDIODENCHIP AUF DER BASIS VON GAN**
GAN-BASED LIGHT-EMITTING-DIODE CHIP
PUCE A DIODE ELECTROLUMINESCENTE A BASE DE GAN

(30) Priorität: 26.04.2000 DE 10020464; 26.05.2000 DE 10026255
(43) Veröffentlichungstag der Anmeldung: 22.01.2003
(60) Teilanmeldung: 10182208.8
(73) Patentinhaber: OSRAM Opto Semiconductors GmbH, 93055 Regensburg (DE)
(72) Erfinder: BADER, Stefan, 93053 Regensburg (DE); HAHN, Berthold, 93155 Hemau (DE); HÄRLE, Volker, 93164 Laaber (DE); LUGAUER, Hans-Jürgen, 93173 Wenzenbach (DE); MUNDBROD-VANGEROW, Manfred, 89312 Günzburg (DE)
(74) Vertreter: Epping - Hermann - Fischer
(86) Internationale Anmeldenummer: PCT/DE2001/001003
(87) Internationale Veröffentlichungsnummer: WO 2001/084640

(56) Entgegenhaltungen:
- EP-A- 0 404 565
- EP-A- 0 740 376
- EP-A- 0 810 674
- WO-A-97/48138
- DE-A- 19 830 838
- DE-A1- 19 820 777
- DE-A1- 19 921 987
- JP-A- 10 290 027
- US-A- 5 585 649
- PATENT ABSTRACTS OF JAPAN vol. 1996, no. 07, 31. Juli 1996 (1996-07-31) & JP 08 064910 A (SANYO ELECTRIC CO), 8. März 1996 (1996-03-08)
- PATENT ABSTRACTS OF JAPAN vol. 1999, no. 12, 29. Oktober 1999 (1999-10-29) & JP 11 191641 A (MATSUSHITA ELECTRON CO), 13. Juli 1999 (1999-07-13)
- PATENT ABSTRACTS OF JAPAN vol. 1998, no. 11, 30. September 1998 (1998-09-30) & JP 10 150220 A (TOYODA GOSEI CO), 2. Juni 1998 (1998-06-02) in der Anmeldung erwähnt
- MENSZ P ET AL: "InGaN/AlGaN violet LEDs with reflective p-contacts" ELECTRONICS LETTERS, 1997, Bd. 33, Seiten 2066-2068, XP000734311 ISSN: 0013-5194
- PATENT ABSTRACTS OF JAPAN vol. 1999, no. 11, 30. September 1999 (1999-09-30) -& JP 11 150297 A (NICHIA CHEM IND), 2. Juni 1999 (1999-06-02)
- PATENT ABSTRACTS OF JAPAN vol. 1999, no. 08, 30. Juni 1999 (1999-06-30) & JP 11 068157 A (SUMITOMO ELECTRIC IND), 9. März 1999 (1999-03-09)
- PATENT ABSTRACTS OF JAPAN vol. 1995, no. 11, 26. Dezember 1995 (1995-12-26) & JP 07 221347 A (NICHIA CHEM IND), 18. August 1995 (1995-08-18)
- PATENT ABSTRACTS OF JAPAN vol. 1998, no. 13, 30. November 1998 (1998-11-30) -& JP 10 209494 A (ROHM CO), 7. August 1998 (1998-08-07)
- PATENT ABSTRACTS OF JAPAN vol. 1996, no. 06, 28. Juni 1996 (1996-06-28) -& JP 08 032116 A (TOYODA GOSEI CO), 2. Februar 1996 (1996-02-02)

## Beschreibung

Die Erfindung bezieht sich auf einen Lumineszenzdiodenchip (LED-Chip) nach dem Oberbegriff des Patentanspruchs 1.

Bei der Herstellung von Lumineszenzdiodenchips auf der Basis von GaN besteht das grundlegende Problem, dass die maximal erzielbare elektrische Leitfähigkeit von p-dotierten Schichten, insbesondere von p-dotierten GaN- oder AlGaN-Schichten, nicht ausreicht, um mit bei herkömmlichen Lumineszenzdiodenchips aus anderen Materialsystemen üblicherweise verwendeten Vorderseitenkontakten, die zur Erzielung möglichst hoher Strahlungsauskopplung nur einen Bruchteil der Vorderseite des Chips bedecken, eine Stromaufweitung über den gesamten lateralen Querschnitt des Chips zu erzielen.

Ein Aufwachsen der p-leitenden Schicht auf ein elektrisch leitendes Substrat, wodurch eine Stromeinprägung über den gesamten lateralen Querschnitt der p-leitenden Schicht möglich wäre, führt zu keinem wirtschaftlich vertretbarem Ergebnis. Die Gründe hierfür sind, dass die Herstellung von elektrisch leitenden gitterangepassten Substraten (z.B. GaN-Substraten) für das Aufwachsen von GaN-basierten Schichten mit hohem technischen Aufwand verbunden ist und dass das Aufwachsen von p-dotierten GaN-basierten Schichten auf für undotierte und n-dotierte GaN-Verbindungen geeignete nicht gitterangepassten Substrate zu keiner für eine Lumineszenzdiode hinreichenden Kristallqualität führt.

Bei einem bekannten Ansatz zur Bekämpfung des oben genannten Problems wird auf die vom Substrat abgewandte Seite der p-leitenden Schicht ganzflächig eine für die Strahlung durchlässige Kontaktschicht oder eine zusätzliche elektrisch gut leitfähige Schicht zur Stromaufweitung aufgebracht, die mit einem Bondkontakt versehen ist.

Der erstgenannte Vorschlag ist jedoch mit dem Nachteil verbunden, dass ein erheblicher Teil der Strahlung in der Kontaktschicht absorbiert wird. Beim zweitgenannten Vorschlag ist ein zusätzlicher Verfahrensschritt erforderlich, der den Fertigungsaufwand erhöht.

Die Druckschrift JP H11-191 641 A ist auf einen LED-Chip mit einer metallischen p-Kontaktstruktur gerichtet.

In der Druckschrift JP H08-064 910 A findet sich ein LED-Chip mit einem SiC-Substrat.

Aus der Druckschrift JP H11-150 297 A ist ein LED-Chip mit einer Kontaktstruktur aus verschiedenen Metallen bekannt.

Das japanische Abstract JP H10-150 220 A offenbart ein lichtemittierendes Halbleiterbauelement, bei dem eine n-GaN Halbleiterschicht, eine lichtemittierenden Schicht und eine p-GaN Halbleiterschicht aufeinanderfolgend auf ein n-GaN-Substrat aufgebracht sind. Auf der Oberfläche der p-GaN Halbleiterschicht ist eine diese im Wesentlichen vollständig bedeckende p-Elektrode angeordnet.

Eine mehrlagige, metallische p-Elektrode für eine LED ist in der Druckschrift JP H10-290 027 A beschrieben.

In dem Artikel Mensz P. et al., "InxGaN1-xN/AlyGa1-yN violet light emitting diodes with reflective p-contacts for high single sided light extraction", veröffentlicht in Electronics Letters, 20. November 1997, Vol. 23, No. 24, Seiten 2066 bis 2068, ist ein LED mit einer reflektierenden Kontaktstruktur offenbart.

Ferner findet sich eine LED auf der Basis von GaN mit einer metallischen Kontaktschicht an einer p-Seite in der Druckschrift DE 198 30 838 A1.

Hinsichtlich einer AlGaAs-LED wird auf die Druckschrift EP 0 404 656 A1 hingewiesen.

In der Druckschrift DE 199 21 987 A1 ist eine LED mit einer p-Kontaktmetallisierung, umfassend mehrere Metalle, wiedergegeben.

Mehrere Metalle für die Elektroden von LEDs sind in der Druckschrift DE 198 20 777 A1 diskutiert, ebenso wie in der Druckschrift US 5 5585 649 A.

Die Aufgabe der Erfindung besteht zunächst darin, einen Lumineszenzdiodenchip der eingangs genannten Art mit einer verbesserten Stromaufweitung zu entwickeln, dessen zusätzlicher Herstellungsaufwand gering gehalten ist.

Diese Aufgabe wird mit einem Lumineszendiodenchip mit den Merkmalen des Patentanspruchs 1 gelöst. Vorteilhafte Weiterbildungen sind Gegenstand der abhängigen Patentansprüche.

Bei einem Lumineszenzdiodenchip gemäß der Erfindung ist das Substrat elektrisch leitfähig. Auf das Substrat sind zunächst die n-leitenden Schichten der Epitaxieschichtenfolge aufgebracht. Auf dieser befinden sich die p-leitenden Schichten der Epitaxieschichtenfolge, gefolgt von einer lateral ganzflächig aufgebrachten reflektierenden, bondfähigen p-Kontaktschicht. Das Substrat ist an seiner von der Epitaxieschichtenfolge abgewandten Hauptfläche mit einer Kontaktmetallisierung versehen, die nur eine Teil dieser Hauptfläche bedeckt. Die Lichtauskopplung aus dem Chip erfolgt über den freien Bereich der Hauptfläche des Substrats und über die Chipflanken.

Das Substrat dient hier vorteilhafterweise als Fensterschicht, die die Auskopplung der im Chip erzeugten Strahlung verbessert. Zur Optimierung der Dicke des Substrats ist dieses vorteilhafterweise nach dem Aufwachsen der Epitaxieschichtenfolge beispielsweise mittels Schleifen und/oder Ätzen gedünnt.

Bei einem weiteren Lumineszenzdiodenchip gemäß der Erfindung weist der Chip ausschließlich Epitaxieschichten auf. Dazu ist ein Aufwachssubstrat nach dem epitaktischen Aufwachsen der Epitaxieschichtenfolge entfernt. Die p-leitende Epitaxieschicht ist auf ihrer von der n-leitenden Epitaxieschicht abgewandten Hauptfläche ganzflächig mit einer reflektierenden, bondfähigen p-Kontaktschicht versehen. Auf der von der p-leitenden Epitaxieschicht abgewandten Hauptfläche der n-leitenden Epitaxieschicht befindet sich eine n-Kontaktschicht, die nur einen Teil dieser Hauptfläche bedeckt. Die Lichtauskopplung aus dem Chip erfolgt über den freien Bereich der Hauptfläche der n-leitenden Epitaxieschicht und über die Chipflanken.

Das Aufwachssubstrat kann in diesem Fall sowohl elektrisch isolierend als auch strahlungsundurchlässig sein und demzufolge vorteilhafterweise allein hinsichtlich optimaler Aufwachsbedingungen ausgewählt werden.

Der besondere Vorteil eines derartigen sogenannten Dünnfilm-LED-Chips besteht in einer verringerten, idealerweise keiner Strahlungsabsorption im Chip und einer verbesserten Auskopplung der Strahlung aus dem Chip, insbesondere aufgrund der verminderten Anzahl von Grenzflächen mit Brechungsindexsprung.

Mit beiden erfindungsgemäßen Lumineszenzdiodenchips ist der besondere Vorteil verbunden, dass die Möglichkeit besteht, den Verlustwärme erzeugenden Bereich (insbesondere die p-dotierte Schicht und den pn-Übergang) des Chips sehr nahe an eine Wärmesenke zu bringen; die Epitaxieschichtenfolge ist praktisch unmittelbar an eine Wärmesenke thermisch ankoppelbar. Dadurch kann der Chip sehr effektiv gekühlt werden, wodurch die Stabilität der ausgesandten Strahlung erhöht ist. Ebenso ist auch der Wirkungsgrad des Chips erhöht.

Bei beiden erfindungsgemäßen Lumineszenzdiodenchips ist aufgrund der ganzflächigen Kontaktierung vorteilhafterweise die Flussspannung reduziert.

Bei den erfindungsgemäßen Lumineszenzdiodenchips besteht die p-Kontaktschicht aus einer auf die p-Seite aufgebrachten transparenten ersten Schicht und einer auf diese aufgebrachte spiegelnde zweite Schicht. Dadurch kann die Kontaktschicht auf einfache Weise sowohl hinsichtlich ihrer elektrischen Eigenschaften als auch ihrer Reflexionseigenschaften optimiert werden.

Materialien für die erste und zweite Schicht sind Pt oder Pd bzw. Ag oder A1.

In einer weiteren bevorzugten Ausführungsform ist die gesamte freie Oberfläche des durch die Schichtenfolge gebildeten Halbleiterkörpers oder ein Teilbereich davon aufgeraut. Durch diese Aufrauung wird die Totalreflektion an der Auskoppelfläche gestört und dadurch mit Vorteil der optische Auskopplungsgrad weiter erhöht.

Bei einem Verfahren zum Herstellen eines Lumineszenzdiodenbauelements mit einem Lumineszenzdiodenchip gemäß der Erfindung wird der Chip mit der p-Seite auf eine Chipmontagefläche eines elektrischen Anschlussteils, insbesondere eines elektrischen Leiterrahmens, montiert.

In einer besonders bevorzugten Weiterbildung wird das Herstellungsverfahren fortgeführt durch eine Aufrauung des durch die Schichtenfolge gebildeten Halbleiterkörpers, wobei die gesamte freie Oberfläche des Halbleiterkörpers oder Teilbereiche hiervon aufgeraut werden. Eine bezüglich der Erhöhung der Lichtausbeute besonders effektive Aufrauung wird durch Anätzen des Halbleiterkörpers oder mittels eines Sandstrahlverfahrens hergestellt.

Weitere vorteilhafte Ausgestaltungen der Erfindung ergeben sich aus den im Folgenden in Verbindung mit den Figuren 1a bis 5 beschriebenen Ausführungsbeispielen. Es zeigen:
Figur 1a, eine schematische Darstellung eines Schnittes durch ein erstes Ausführungsbeispiel;
Figur 1b, eine schematische Darstellung eines bevorzugten p-Kontaktschicht ;
Figur 2, eine schematische Darstellung eines Schnittes durch ein zweites Ausführungsbeispiel;
Figuren 3a bis 3c, eine schematische Darstellung eines Verfahrensablaufes zur Herstellung des Ausführunsbeispieles gemäß Figur 1a;
Figuren 4a bis 4e, eine schematische Darstellung eines Verfahrensablaufes zur Herstellung des Ausführunsbeispieles gemäß Figur 2;
Figur 5, eine schematische Schnittansicht eines weiteren Ausführungsbeispiels eines erfindungsgemäßen Lumineszenzdiodenchips.

In den Figuren der verschiedenen Ausführungsbeispiele sind gleiche oder gleichwirkende Bestandteile jeweils mit denselben oder ähnlichen Bezugszeichen versehen.

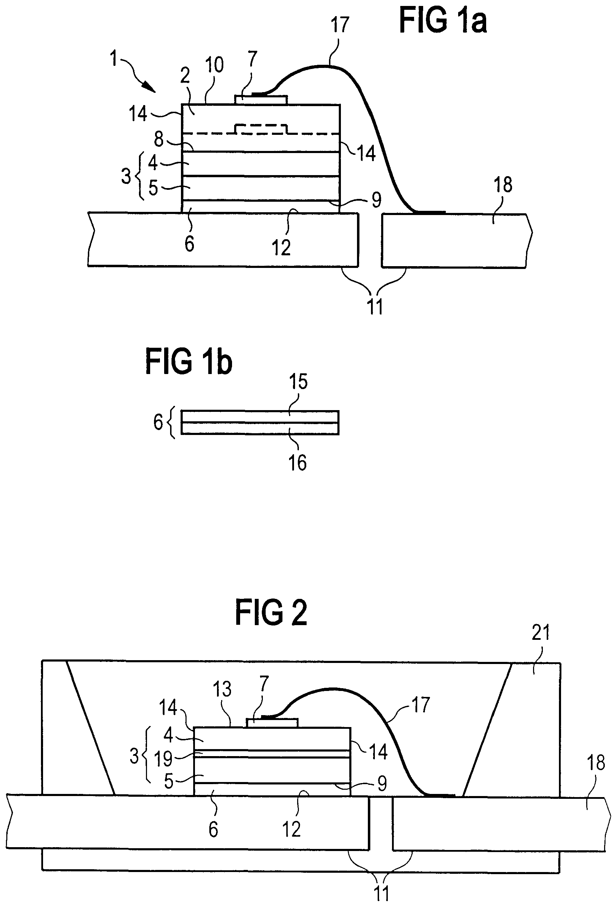

Bei dem Lumineszenzdiodenchip 1 von Figur 1a ist auf einem SiC-Substrat 2 eine strahlungsemittierende Epitaxieschichtenfolge 3 aufgebracht. Diese weist eine n-leitend dotierte GaN- oder AlGaN-Epitaxieschicht 4 und eine p-leitend dotierte GaN- oder AlGaN-Epitaxieschicht 5 auf. Ebenso kann beispielsweise eine auf GaN basierende Epitaxieschichtenfolge 3 mit einer Doppelheterostruktur, einer Einfach-Quantenwell(SQW)-Struktur oder einer Multi-Quantenwell(MQW)-Struktur mit einer bzw. mehreren undotierten Schicht(en) 19, beispielsweise aus InGaN oder InGaAlN, vorgeshen sein.

Das SiC-Substrat 2 ist elektrisch leitfähig und für die von der Epitaxieschichtenfolge 3 ausgesandte Strahlung durchlässig.

Auf ihrer vom SiC-Substrat 2 abgewandten p-Seite 9 ist auf die Epitaxieschichtenfolge 3 ganzflächig eine reflektierende, bondfähige p-Kontaktschicht 6 aufgebracht.

Die p-Kontaktschicht 6, wie in Figur 1b schematisch dargestellt, ist aus einer strahlungsdurchlässigen ersten Schicht 15 und einer spiegelnden zweiten Schicht 16 zusammengesetzt. Die erste Schicht 15 besteht im Wesentlichen aus Pt oder Pd und die zweite Schicht 16 im Wesentlichen aus Ag oder Al.

An seiner von der Epitaxieschichtenfolge 3 abgewandten Hauptfläche 10 ist das SiC-Substrat 2 mit einer Kontaktmetallisierung 7 versehen, die nur einen Teil dieser Hauptfläche 10 bedeckt und als Bondpad zum Drahtbonden ausgebildet ist.

Die Kontaktmetallisierung 7 besteht beispielsweise aus einer auf das SiC-Substrat 2 aufgebrachten Ni-Schicht, gefolgt von einer Au-Schicht.

Der Chip 1 ist mittels Die-Bonden mit seiner p-Seite, das heißt mit der p-Kontaktschicht 6 auf eine Chipmontagefläche 12 eines elektrischen Anschlußrahmens 11 (Leadframe) montiert. Die n-Kontaktmetallisierung 7 ist über einen Bonddraht 17 mit einem Anschlußteil 18 des Anschlußrahmens 11 verbunden.

Die Lichtauskopplung aus dem Chip 1 erfolgt über den freien Bereich der Hauptfläche 10 des SiC-Substrats 2 und über die Chipflanken 14.

Optional weist der Chip 1 ein nach dem Aufwachsen der Epitaxieschichtenfolge 3 gedünntes SiC-Substrat 2 auf (dies ist in Figur 1a mit Hilfe der gestrichelten Linien angedeutet).

Das in Figur 2 dargestellte Ausführungsbeispiel unterscheidet sich von dem der Figur 1a zum einen dadurch, dass der Chip 1 ausschließlich Epitaxieschichten der Epitaxieschichtenfolge 3 und keine Substratschicht aufweist. Letztere wurde nach dem Aufwachsen der Epitaxieschichten beispielsweise mittels Ätzen und/oder Schleifen entfernt. Hinsichtlich der Vorteile eines derartigen sogenannten Dünnfilm-LED-Chips wird auf den allgemeinen Teil der Beschreibung verwiesen. Zum anderen weist die Epitaxieschichtenfolge 3 eine Doppelheterostruktur, eine Einfach-Quantenwell(SQW)-Struktur oder eine Multi-Quantenwell(MQW)-Struktur mit einer bzw. mehreren undotierten Schicht(en) 19, beispielsweise aus InGaN oder InGaAlN auf. Beispielhaft ist hier auch ein Lumineszenzdiodengehäuse (LED-Gehäuse) 21 schematisch dargestellt.

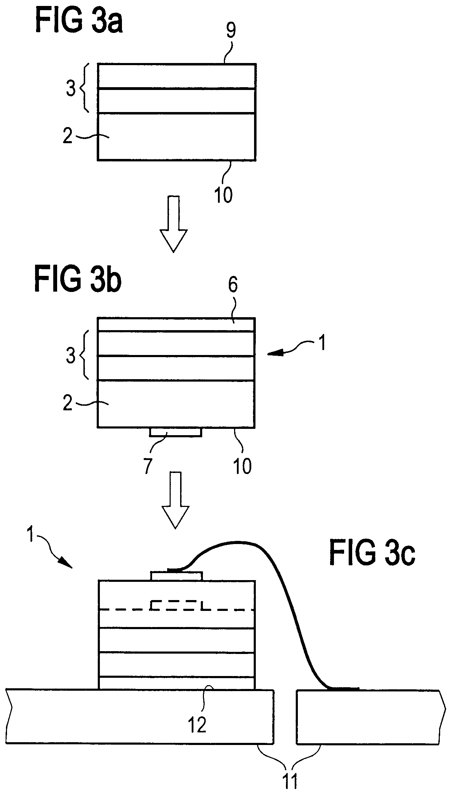

Bei dem in den Figuren 3a bis 3c schematisch dargestellten Verfahrensablauf zum Herstellen eines Lumineszenzdiodenbauelements mit einem Lumineszenzdiodenchip 1 gemäß Figur 1a wird zunächst die strahlungsemittierende Epitaxieschichtenfolge 3 auf das SiC-Substrat 2 aufgewachsen (Figur 3a). Nachfolgend wird auf die p-Seite 9 der Epitaxieschichtenfolge 3 ganzflächig die bondfähige p-Kontaktschicht 6 und auf einen Teilbereich der von der Epitaxieschichtenfolge 3 abgewandten Hauptfläche 10 des Substrats 2 die n-Kontaktschicht 7 aufgebracht (Figur 3b). Diese Prozess-Schritte finden alle im sogenannten Waferverbund statt, wodurch eine Vielzahl von Chips gleichzeitig nebeneinander herstellbar sind.

Nach den oben beschriebenen Prozess-Schritten wird der Waferverbund in einzelne Chips 1 zertrennt. Die einzelnen Chips werden anschließend mittels Löten jeweils mit der bondfähigen p-Kontaktschicht 6 auf eine Chipmontagefläche 12 eines elektrischen Leiterrahmens 11 montiert (Figur 3c).

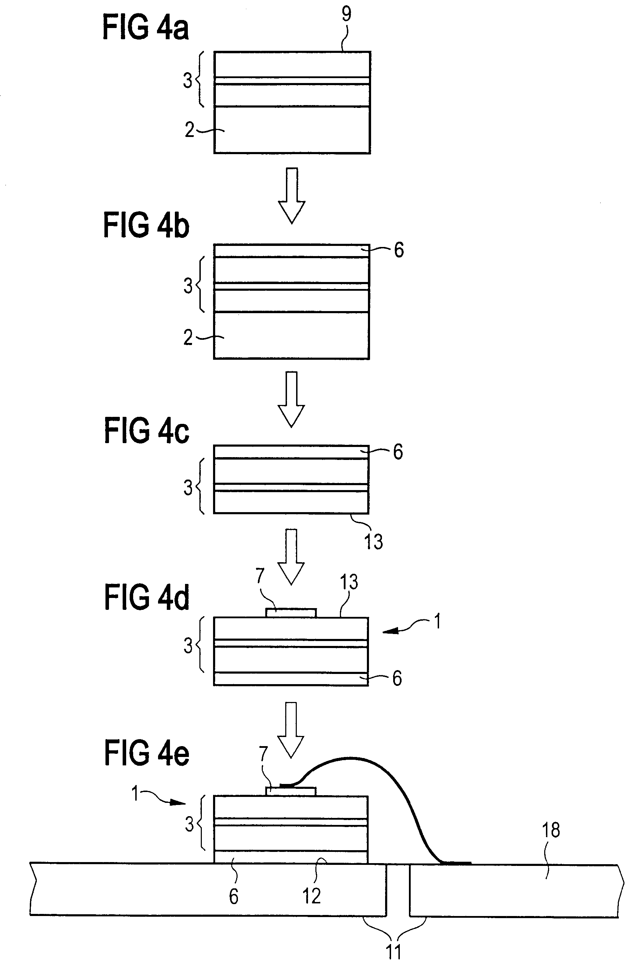

Das in den Figuren 4a bis 4e schematisch dargestellte Verfahren zum Herstellen eines Lumineszenzdiodenbauelements mit einem Lumineszenzdiodenchip 1 gemäß Figur 2 unterscheidet sich von dem der Figuren 3a bis 3c im Wesentlichen dadurch, dass nach dem Aufwachsen der Epitaxieschichtenfolge 3 und vor oder nach dem Aufbringen der p-Kontaktschicht 6 das Substrat 2 entfernt wird (Figur 4c). Das Substrat 2 kann in diesem Fall sowohl elektrisch isolierend als auch strahlungsundurchlässig sein und demzufolge vorteilhafterweise allein hinsichtlich optimaler Aufwachsbedingungen ausgelegt werden.

Nach dem Entfernen des Substrats 2 wird auf die n-Seite 13 der Epitaxieschichtenfolge 3 die n-Kontaktmetallisierung 7 aufgebracht (Figur 4d), bevor dann analog die oben in Verbindung mit der Figur 3c bereits beschriebenen Montageschritte erfolgen (Figur 4e).

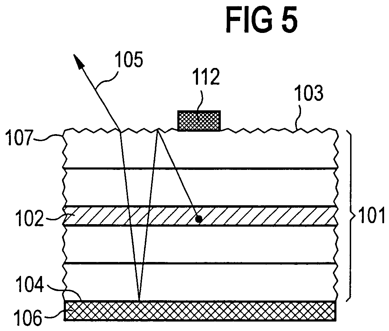

Das in Figur 5 dargestellte Ausführungsbeispiel weist eine Mehrzahl von stapelförmig angeordneten, unterschiedlichen Halbleiterschichten 101 auf, die aus GaN oder einer darauf basierenden ternären oder quaternären Verbindung bestehen. Im Betrieb bildet sich innerhalb dieser Schichten eine aktive Zone 102 aus, in der die Strahlung 105 generiert wird.

Der Schichtstapel wird von einer ersten Hauptfläche 103 und einer zweiten Hauptfläche 104 begrenzt. Im Wesentlichen wird die erzeugte Strahlung 105 durch die erste Hauptfläche 103 in die angrenzende Umgebung ausgekoppelt.

Auf der zweiten Hauptfläche 104 ist eine reflektierende, bondfähige p-Kontaktschicht 106 aufgebracht, wie weiter oben beschrieben. Kontaktiert wird der Halbleiterkörper auf der Auskopplungsseite über die Kontaktfläche 112 sowie reflektorseitig über die p-Kontaktschicht 106. Die reflektorseitige Kontaktierung kann beispielsweise dadurch erfolgen, dass der Halbleiterkörper reflektorseitig auf einen Metallkörper aufgesetzt ist, der sowohl als Träger wie auch der Stromzuführung dient.

Der Reflektor 106 bewirkt, dass ein Teil der Strahlung 105, die bei der Auskopplung an der ersten Hauptfläche 103 in den Halbleiterkörper zurückreflektiert wird, wiederum in Richtung der ersten Hauptfläche 103 reflektiert wird, sodass insgesamt die durch die erste Hauptfläche 103 ausgekoppelte Strahlungsmenge erhöht wird. Diese Erhöhung wird dadurch ermöglicht, dass das Bauelement als Dünnschichtbauelement ohne stahlungsabsorbierendes Substrat ausgeführt ist und der Reflektor 106 direkt auf dem GaN-Halbleiterkörper aufgebracht ist.

Die Oberfläche des Halbleiterkörpers weist dabei eine Aufrauung 107 auf. Diese Aufrauung 107 bewirkt eine Streuung der Strahlung 105 an der ersten Hauptfläche 103, sodass die Totalreflexion an der ersten Hauptfläche 103 gestört wird. Weitergehend verhindert diese Streuung, dass die erzeugte Strahlung durch fortlaufende, gleichartige Reflexionen zwischen den beiden Hauptflächen 103 und 104 bzw. dem Reflektor 106 nach Art eines Lichtleiters geführt wird, ohne den Halbleiterkörper zu verlassen. Somit wird durch die Aufrauhung 107 die Lichtausbeute weiter erhöht.

## Patentansprüche

1. Lumineszenzdiodenchip (1) mit einer strahlungsemittierenden Epitaxieschichtenfolge (3) auf der Basis von GaN, die eine n-leitende Epitaxieschicht (4) und eine p-leitende Epitaxieschicht (5) aufweist;
wobei
- die p-leitende Epitaxieschicht (5) auf ihrer von der n-leitenden Epitaxieschicht (4) abgewandten Hauptfläche (9) ganzflächig mit einer reflektierenden, bondfähigen p-Kontaktschicht (6) versehen ist,
- die p-Kontaktschicht (6) aus einer direkt auf die p-Seite (9) aufgebrachten transparenten ersten Schicht (15) und einer direkt auf dieser aufgebrachten spiegelnden zweiten Schicht (16) besteht und die erste Schicht (15) Pt oder Pd aufweist und die zweite Schicht (16) Ag oder Al aufweist;
wobei
- der Lumineszenzdiodenchip auf seiner von der p-leitenden Epitaxieschicht (5) abgewandten Hauptfläche (8, 10) mit einer n-Kontaktschicht (7) versehen ist, die nur einen Teil dieser Hauptfläche bedeckt, und
- die Lichtauskopplung aus dem Chip (1) über den freien Bereich der Hauptfläche (8, 10) und über die Chipflanken (14) erfolgt; und wobei
- die Hauptfläche (8,10) eine von der Epitaxieschichtenfolge (3) abgewandte Hauptfläche (10) eines elektrisch leitfähigen Substrats (2) ist, das für eine von der Epitaxieschichtenfolge (3) ausgesandte Strahlung durchlässig ist und auf das die Epitaxieschichtenfolge (3) mit der n-leitenden Seite (8) aufgebracht ist,
oder
- die Hauptfläche (8,10) eine von der p-leitenden Epitaxieschicht (5) abgewandte Hauptfläche (8) der n-leitenden Epitaxieschicht (4) ist.

2. Lumineszenzdiodenchip (1) nach Anspruch 1,
bei dem die Hauptfläche (8,10) die Hauptfläche (10) des elektrisch leitfähigen Substrats (2) ist und das Substrat (2) ein Siliziumcarbid-Substrat ist.

3. Lumineszenzdiodenchip (1) nach einem der vorigen Ansprüche,
bei dem die gesamte freie Oberfläche der Schichtfolge (3, 101) oder ein Teilbereich davon aufgeraut ist.

4. Lumineszenzdiodenbauelement mit einem Lumineszenzdiodenchip gemäß einem der Patentansprüche 1 bis 3, bei dem der Lumineszenzdiodenchip (1) auf einer Chipmontagefläche (12) eines Lumineszenzdiodengehäuses (21), montiert ist,
wobei die reflektierende Kontaktmetallisierung (6) auf der Chipmontagefläche (12) aufliegt.

5. Lumineszenzdiodenbauelement nach Anspruch 4,
wobei der Lumineszenzdiodenchip (1) auf einem Leiterrahmen (11) des Lumineszenzdiodengehäuses (21) montiert ist.

6. Lumineszenzdiodenbauelement nach Anspruch 4,
wobei der Lumineszenzdiodenchip (1) auf einer Leiterbahn des Lumineszenzdiodengehäuses (21) montiert ist.

## Claims

1. Luminescence diode chip (1) comprising a radiation-emitting epitaxial layer sequence (3) on the basis of GaN, which comprises an n-conducting epitaxial layer (4) and a p-conducting epitaxial layer (5);
wherein
- the p-conducting epitaxial layer (5), on its main surface (9) facing away from the n-conducting epitaxial layer (4), is provided with a reflective, bondable p-type contact layer (6) over the whole area,
- the p-type contact layer (6) consists of a transparent first layer (15), which is applied directly to the p-side (9), and a specularly reflective second layer (16), which is applied directly on said first layer, and the first layer (15) comprises Pt or Pd and the second layer (16) comprises Ag or Al;
wherein
- the luminescence diode chip is provided with an n-type contact layer (7) on its main surface (8, 10) facing away from the p-conducting epitaxial layer (5), said n-type contact layer covering only part of said main surface, and
- light is coupled out from the chip (1) via the free region of the main surface (8, 10) and via the chip sidewalls (14); and
- the main surface (8, 10) is a main surface (10) of an electrically conductive substrate (2) facing away from the epitaxial layer sequence (3), said electrically conductive substrate being transmissive to radiation emitted by the epitaxial layer sequence (3) and the epitaxial layer sequence (3) being applied to said electrically conductive substrate by the n-conducting side (8),
or
- the main surface (8, 10) is a main surface (8) of the n-conducting epitaxial layer (4) facing away from the p-conducting epitaxial layer (5).

2. Luminescence diode chip (1) according to Claim 1,
wherein the main surface (8, 10) is the main surface (10) of the electrically conductive substrate (2) and the substrate (2) is a silicon carbide substrate.

3. Luminescence diode chip (1) according to either of the preceding claims,
wherein the entire free surface of the layer sequence (3, 101) or a partial region thereof is roughened.

4. Luminescence diode component comprising a luminescence diode chip according to any of Patent Claims 1 to 3,
wherein the luminescence diode chip (1) is mounted on a chip mounting surface (12) of a luminescence diode housing (21),
wherein the reflective contact metallization (6) bears on the chip mounting surface (12).

5. Luminescence diode component according to Claim 4,
wherein the luminescence diode chip (1) is mounted on a leadframe (11) of the luminescence diode housing (21).

6. Luminescence diode component according to Claim 4,
wherein the luminescence diode chip (1) is mounted on a conductor track of the luminescence diode housing (21).

## Revendications

1. Puce de diode électroluminescente (1) comprenant une séquence de couches épitaxiales (3) émettrices de rayonnement à base de GaN, laquelle possède une couche épitaxiale à conduction n (4) et une couche épitaxiale à conduction p (5) ;
- la couche épitaxiale à conduction p (5) étant pourvue, sur sa surface principale (9) à l'opposé de la couche épitaxiale à conduction n (4), d'une couche de contact p (6) réfléchissante apte à être liée,
- la couche de contact p (6) étant constituée d'une première couche (15) transparente appliquée directement sur le côté p (9) et d'une deuxième couche (16) réfléchissante appliquée directement sur celle-ci, et la première couche (15) possédant du Pt ou du Pd et la deuxième couche (16) possédant de l'Ag ou de l'Al ;
- la puce de diode électroluminescente étant pourvue, sur sa surface principale (8, 10) à l'opposé de la couche épitaxiale à conduction p (5), d'une couche de contact n (7) qui ne recouvre qu'une partie de cette surface principale, et
- le découplage de la lumière hors de la puce (1) s'effectuant par le biais de la zone libre de la surface principale (8, 10) et par le biais des flancs de la puce (14) ; et
- la surface principale (8, 10) étant une surface principale (10) à l'opposé de la séquence de couches épitaxiales (3) d'un substrat (2) électriquement conducteur, lequel est transparent pour le rayonnement émis par la séquence de couches épitaxiales (3) et sur lequel est appliquée la séquence de couches épitaxiales (3) par le côté à conduction n (8),
ou
- la surface principale (8, 10) étant une surface principale (8) de la couche épitaxiale à conduction n (4) à l'opposé de la couche épitaxiale à conduction p (5).

2. Puce de diode électroluminescente (1) selon la revendication 1, avec laquelle la surface principale (8, 10) est la surface principale (10) du substrat (2) électriquement conducteur et le substrat (2) est un substrat au carbure de silicium.

3. Puce de diode électroluminescente (1) selon l'une des revendications précédentes, avec laquelle la totalité de la surface libre de la séquence de couches (3, 101) ou une zone partielle de celle-ci est rendue rugueuse.

4. Composant diode électroluminescente comprenant une puce de diode électroluminescente selon l'une des revendications 1 à 3, avec lequel la puce de diode électroluminescente (1) est montée sur une surface de montage de puce (12) d'un boîtier de diode électroluminescente (21), la métallisation de contact (6) réfléchissante reposant sur la surface de montage de puce (12).

5. Composant diode électroluminescente selon la revendication 4, la puce de diode électroluminescente (1) étant montée sur un cadre conducteur (11) du boîtier de diode électroluminescente (21).

6. Composant diode électroluminescente selon la revendication 4, la puce de diode électroluminescente (1) étant montée sur une piste conductrice du boîtier de diode électroluminescente (21).
